# FASCICULE DE BREVET EUROPEEN

(11) **EP 0 778 668 B1**
(45) Date de publication et mention de la délivrance du brevet: **10.07.2002**
(21) Numéro de dépôt: 96402630.6
(22) Date de dépôt: 05.12.1996
(51) Int. Cl.: H03H 17/02

(54) **Dispositif de décimation de séquences de données numériques**
Dezimator für digitale Datenfolgen
Decimator for digital data sequences

(30) Priorité: 06.12.1995 FR 9514430
(43) Date de publication de la demande: 11.06.1997
(73) Titulaire: THOMSON multimedia, 92648 Boulogne Cédex (FR)
(72) Inventeur: Pirson, Alain, 92050 Paris la Defense Cedex (FR); Kazi, Farid, 92050 Paris la Defense Cedex (FR)
(74) Mandataire: Ruellan-Lemonnier, Brigitte

(56) Documents cités:
- EP-A- 0 438 782
- WO-A-91/19393
- US-A- 4 204 227
- PATENT ABSTRACTS OF JAPAN vol. 017, no. 695 (E-1480), 20 Décembre 1993 & JP 05 236345 A (NEC IC MICROCOMPUT SYST LTD), 10 Septembre 1993,

## Description

La présente invention concerne un dispositif de décimation de séquences de données représentant des échantillons numériques d'un signal à sous-échantillonner dont les échantillons successifs sont représentés par les éléments matriciels successifs d'une matrice de N lignes et M colonnes.

La décimation est une opération qui consiste à réduire la taille d'un bloc de données et repose sur un filtrage de type passe-bas suivi d'un sous-échantillonnage.

Le bloc de données traité peut être bidimensionnel, telle qu'une image numérique comportant N/2 lignes paires constituant une trame paire et N/2 lignes impaires constituant une trame impaire. Dans ce cas, la décimation consiste à réduire la taille et la résolution de l'image traitée. Une des techniques les plus utilisées consiste à remplacer une série de points voisins de l'image par la moyenne de ceux-ci. Le facteur de décimation définit le mode de décimation et correspond au nombre de points moyennés et remplacés par un seul point.

Les dispositifs utilisés dans l'art antérieur pour effectuer cette opération comportent généralement plusieurs étages de calcul montés en cascade, chaque étage réalisant périodiquement le moyennage des données qu'il reçoit de l'étage précédent pendant un cycle de calcul d'au moins une période d'horloge.

De tels dispositifs requièrent un nombre important d'opérateurs contribuant à l'accroissement du coût de leur fabrication.

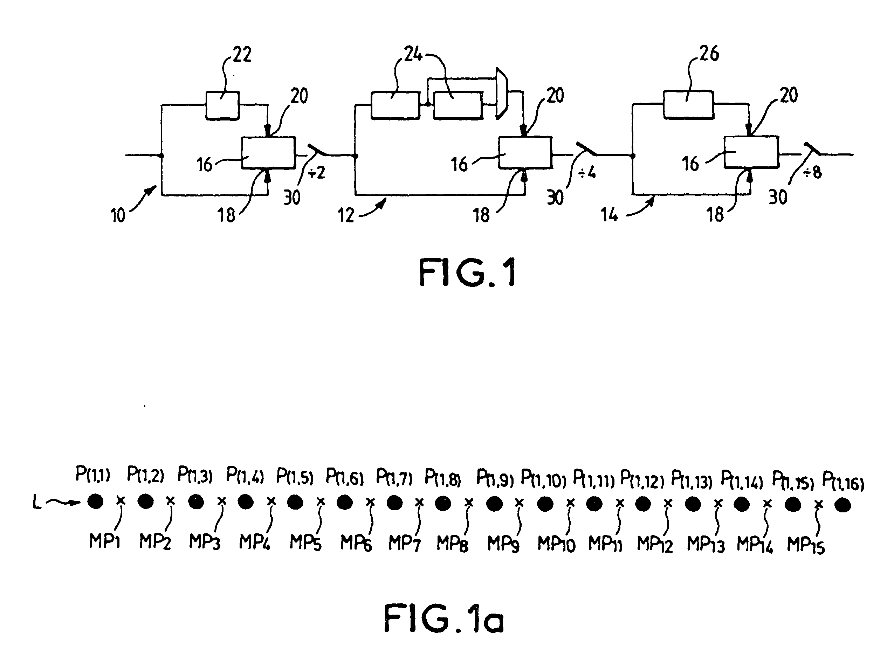

Sur la figure 1 est représentée schématiquement une structure illustrant un dispositif de décimation de l'art antérieur comportant trois étages 10, 12 et 14 montés en cascade. Chacun des trois étages 10, 12 et 14 comporte un additionneur 16 à deux entrées 18 et 20, l'entrée 18 recevant les données à décimer tandis que l'entrée 20 reçoit lesdites données à travers un opérateur de retard (22, 24, 26). Ledit additionneur 16 étant relié via un dispositif d'échantillonnage 30, aux entrées 18 et 20 de l'additionneur de l'étage suivant.

Outre le nombre important d'opérateurs qu' ils contiennent, les dispositifs de décimation de ce type ne permettent pas une utilisation optimale des différents étages de calcul. En effet, les opérations réalisées par ces dispositifs se font séquentiellement pendant plusieurs cycles de calcul successifs au cours desquels ils produisent alternativement un résultat utile représentant la moyenne d'un premier échantillon P(i,j) et d'un deuxième échantillon P(i,j+1) obtenue au cours d' un premier cycle de calcul, et un résultat inutile représentant la moyenne de l'échantillon P(i,j+1) et de l'échantillon P (i,j+2) obtenue au cours du cycle de calcul suivant. Or, seul le résultat utile est pris en compte dans l'opération de décimation. Un tel fonctionnement est illustré par la figure 1a, représentant par exemple seize pixels P(1,1) à P(1,16), situés sur une ligne L, d'une image numérique. Dans ce cas, la décimation des données numériques représentant lesdits pixels consiste à remplacer deux pixels adjacents, par un seul pixel. A cet effet, l'étage 10 du dispositif de la figure 1 réalise successivement le calcul de la moyenne MP1 des données numériques représentant les pixels P(1,1) et P(1,2), puis celui de la moyenne MP2 correspondant aux pixels P(1,2) et P(1,3), puis celui de la moyenne MP3 correspondant aux pixels P(1,3) et P(1,4), puis celui de la moyenne MP4 correspondant aux pixels P(1,4) et P(1,5), puis celui de la moyenne MP5 correspondant aux pixels P(1,5) et P(1,6).et ainsi de suite jusqu'à la moyenne MP15 correspondant aux pixels P(1,15) et P(1,16). Comme on peut le constater, l'étage 10 permet de calculer quinze moyennes différentes MP1 à MP15 parmi lesquelles seules les moyennes portant un indice impair sont utiles, autrement dit, l'étage 10 produit seulement 50% de résultats utiles au cours d' un cycle de calcul. En effet, chacune des moyennes portant un indice pair MP2, MP4, MP6....MP14 fait intervenir les données numériques correspondant au pixel P(1,2), P(1,4), P(1,6).....P(1,14) qui sont déjà utilisées dans le calcul des moyennes portant un indice impair MP1, MP3, MP5......MP15 et qui représentent les résultats utiles. L'étage 12 permet ensuite de calculer les moyennes successives des données numériques représentant les pixels obtenus par le calcul de l'étage 10 et produit 50% de résultats utiles à partir des résultats précédemment calculés, soit seulement 25% de résultats utiles, obtenus à partir des données reçues par l'étage 10. De même, l'étage 14 produira 50% de résultats utiles à partir des 25% des résultats reçus, soit 12,5% de résultats utiles obtenus à partir des données reçues par l'étage 10.

Le but de l'invention est, d'une part, de réduire le nombre d'étages du dispositif et partant le nombre d'opérateurs nécessaires pour réaliser la décimation et, d'autre part, d'optimiser l'utilisation des opérateurs de calculs utilisés.

Selon l'invention, le dispositif de décimation comporte un étage de multiplexage ayant une pluralité d'entrées monté en cascade avec un étage de calcul propre à effectuer, alternativement, pendant un premier cycle de calcul, la moyenne Mᵢ d'au moins deux séquences représentant les échantillons P(i,j) et P(i,j+1) situés sur une ligne Lᵢ, i variant de 0 à N-1 et j variant de 0 à M-1, et pendant le cycle de calcul suivant, la moyenne Mc de la moyenne Mi obtenue, et d'une séquence intermédiaire préalablement calculée et mémorisée dans un moyen de stockage, ladite séquence intermédiaire représentant la moyenne Mᵢ₋₁ d'au moins deux échantillons P(i-1,j) et P(i-1,j+1) situés sur la ligne L_{i-1.}

Grâce au dispositif selon l'invention, l'opération de décimation est réalisée avec un nombre réduit d'opérateurs. En outre, les cycles de calcul qui produisaient des résultats inutiles dans les dispositifs de l'art antérieur sont utilisés pour calculer un résultat utile. En effet, la mémorisation de la moyenne Mi-1 permet d'intercaler le calcul de la moyenne Mc entre les calculs successifs des deux moyennes Mi-1 et Mi représentant respectivement au moins deux échantillons situés sur la ligne Li-1, et au moins deux échantillons situés sur la ligne Li.

Selon une autre caractéristique de l'invention, le dispositif de décimation comporte en outre un module de commande fournissant, dune part, à l'étage de calcul un signal k permettant de sélectionner un mode parmi une pluralité de modes de décimation possibles, et d'autre part, à l'étage de multiplexage , un signal m permettant d'aiguiller vers l'étage de calcul, au moins deux séquences parmi les séquences reçues, corrélativement au mode de décimation sélectionné.

D'autres caractéristiques et avantages de l'invention ressortiront de la description qui va suivre, prise à titre d'exemple non limitatif, en référence aux figures annexées dans lesquelles:
- la figure 1 représente schématiquement une structure d'un dispositif de décimation de l'art antérieur;
- la figure 1a illustre schématiquement une décimation des données représentant les pixels d'une ligne d'une image numérique au moyen du dispositif de la figure 1.
- la figure 2 représente un schéma-bloc illustrant un dispositif de décimation selon l'invention;
- la figure 3 représente un dispositif selon un mode préféré de réalisation de l'invention;
- La figure 4 représente des diagrammes temporels illustrant un exemple d'utilisation du dispositif de la figure 3;
- les figures 5 et 6 illustrent des chemins empruntés par les données traitées conformément à l'exemple d'utilisation de la figure 4.

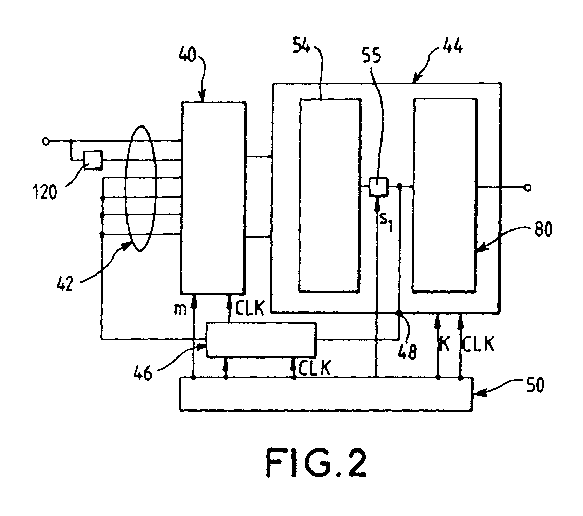

La figure 2 représente un dispositif de décimation de séquences de données représentant des valeurs des échantillons d'un signal à sous-échantillonner, chacun desdits échantillons étant représenté par un élément matriciel P(i,j) d'une matrice de N lignes et M colonnes. Comme on peut le voir sur la figure 2, le dispositif de décimation comporte un étage de multiplexage 40 ayant une pluralité d'entrées 42 monté en cascade avec un étage de calcul 44 propre à effectuer, alternativement, pendant un premier cycle de calcul, la moyenne Mi d'au moins deux séquences représentant les échantillons P(i,j) et P(i,j+1) situés sur une ligne Li, i variant de 0 à N-1 et j variant de 0 à M-1, et pendant le cycle de calcul suivant, la moyenne Mc de la moyenne Mi obtenue, et d'une séquence intermédiaire préalablement calculée et mémorisée dans un moyen de stockage 46, ladite séquence intermédiaire représentant la moyenne Mi-1 d'au moins deux échantillons P(i-1, j) et P(i-1,j+1) situés sur la ligne Li-1.

Dans une application particulière de l'invention, chaque élément matriciel P(i,j) représente les échantillons d'un signal vidéo envoyé à un pixel d'une image numériques de N lignes et M colonnes.

Le dispositif représenté à la figure 2 comporte en outre un module de commande 50 fournissant, d'une part, à l'étage de calcul 44 un signal k permettant de sélectionner un mode parmi une pluralité de modes de décimation possibles, et d'autre part, à rétage de multiplexage 40, un signal m permettant d'aiguiller vers l'étage de calcul 44, au moins deux séquences parmi les séquences reçues, corrélativement au mode de décimation sélectionné.

Par ailleurs, l'étage de calcul 44 comporte un additionneur 54 relié via un premier registre tampon 55 à un diviseur programmable 80. Le diviseur 80 reçoit du moyen de commande 50 un signal représentant un coefficient de division choisi corrélativement au mode de décimation sélectionné, et ledit registre tampon 55 reçoit du moyen de commande 50 un signal périodique si commandant le transfert vers le moyen de stockage 46 des séquences correspondant à des résultats utiles calculés par l'additionneur 54

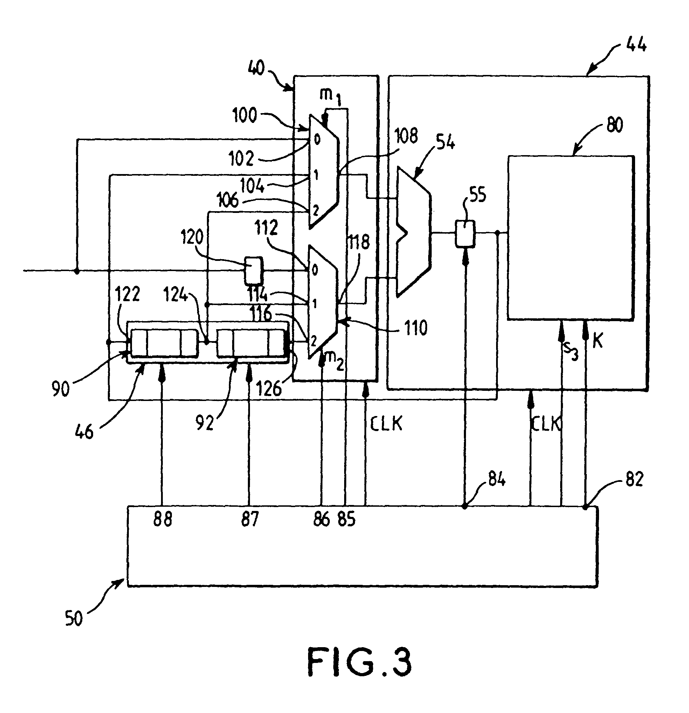

Selon un mode de réalisation préféré de l'invention représenté à la figure 3 et permettant de décimer un bloc d'image de 8 lignes et 8 colonnes, le moyen de stockage 46 est agencé entre une sortie de l'étage de calcul 44 et rune au moins des entrées 42 de l'étage de multiplexage 40, et est constitué par un premier registre 90 associé à un deuxième registre 92, chacun desdits registres 90 et 92 étant destiné à stocker les échantillons numériques correspondant aux signaux vidéo d'au moins quatre pixels de l'image traitée.

Selon ce mode de réalisation, l'étage de multiplexage 40 comporte deux multiplexeurs, soit un premier multiplexeur 100 comportant trois entrées 102, 104, 106 et une sortie 108, et recevant du moyen de commande 50 un signal m1 de sélection de l'une des entrées 102, 104 ou 106 et un deuxième multiplexeur 110 comportant trois entrées 112, 114, 116 et une sortie 118, et recevant du moyen de commande 50 un signal de sélection m2 de l'une des entrées 112, 114 ou 116, lesdits multiplexeurs 100 et 110 sont assemblés de telle sorte que l'entrée 102 reçoive directement une séquence de données numériques, l'entrée 112 soit reliée à l'entrée 102 à travers un opérateur de retard 120, l'entrée 104 soit reliée à une première borne 122 du registre 90, les entrées 106 et 114 soient reliées à une deuxième borne 124, commune aux registres 90 et 92 et l'entrée 116 soit reliée à une troisième borne 126 dudit registre 92.

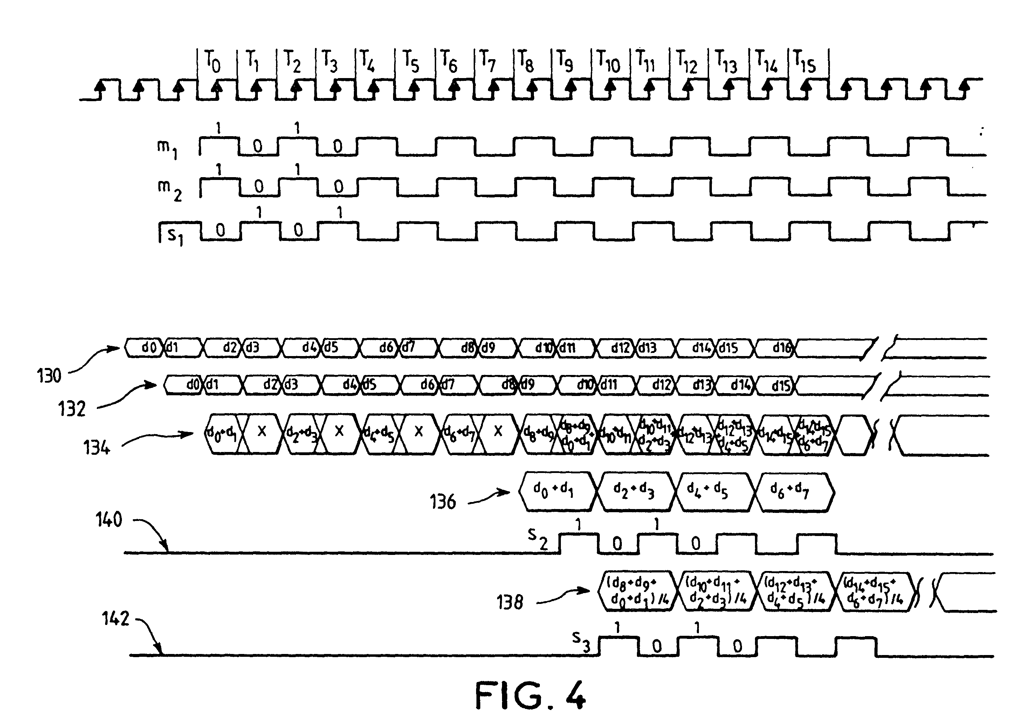

La figure 4 illustre le fonctionnement en mode 4 du dispositif de la figure 3 par des chronogrammes représentant les différents signaux délivrés par le moyen de commande 50. Les adresses respectives des entrées 102, 104, 106 (respectivement des entrées 112, 114, 116) sont représentées par les chiffres 0, 1, et 2. Ainsi la sélection sur le multiplexeur 100 (respectivement sur le multiplexeur 110 ) de l'une des entrées 102, 104, 106 (respectivement 112, 114, 116) d'adresses respectives 0, 1, ou 2 s'obtient en donnant à m1 ( respectivement à m2 ) l'une des valeurs 0, 1, ou 2. Dans cet exemple d'utilisation du dispositif de décimation, le moyen de commande 50 fournit aux différents étages constituant le dispositif de décimation un signal de synchronisation CLK ayant une fréquence de 27 MHz, et les signaux m1 et m2 sont constitués par deux séquences identiques dont les niveaux varient périodiquement entre un état Haut (1) et un état Bas (0). Le signal s1 est synchrone avec les signaux m1 et m2 et est constitué par une séquence périodique dont les niveaux successifs varient symétriquement par rapport aux niveaux des signaux m1 et m2. Les lignes 130, 132, 134, 136 et 138 représentent respectivement les donnés appliquées à rentrée 102, les données successives contenues dans le deuxième registre tampon 120, les données successives recueillies dans le premier registre tampon 55, les données successives mémorisées dans le moyen de stockage 46 et les données successives recueillies à la sortie du diviseur 80.

Sur la ligne 130 sont représentées les données d0 à d16 appliquées périodiquement à l'entrée 102 tandis que sur la ligne 132 sont représentées les données appliquées, avec un décalage d'une période, à l'entrée 112. Sur les lignes 140 et 142 sont représentés respectivement un deuxième signal s2 à deux états logiques et un signal s3 de validation des résultats obtenus à la sortie du diviseur 80.

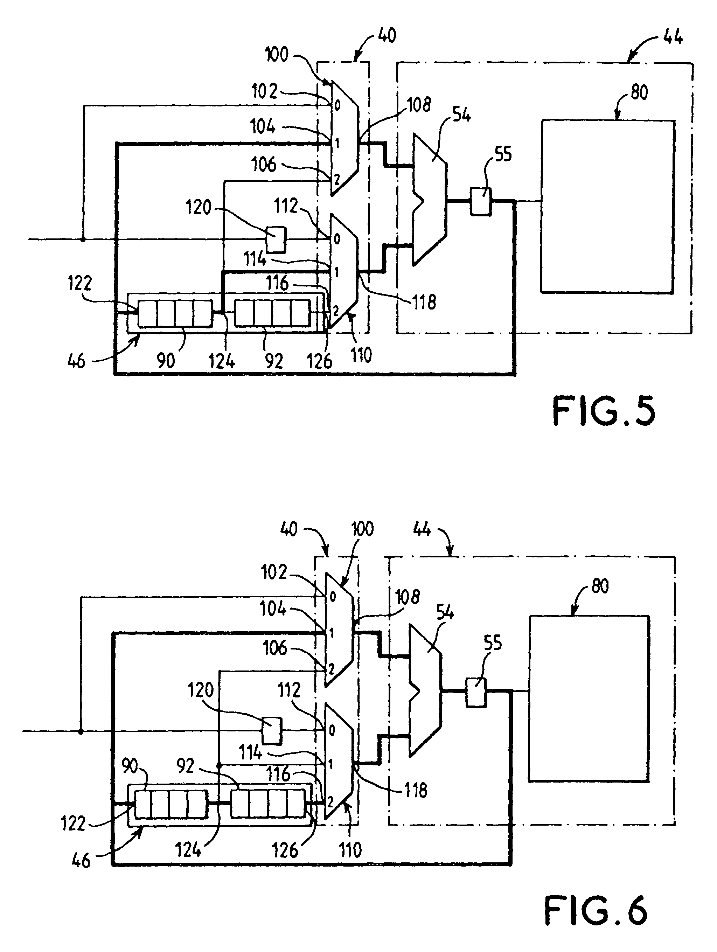

Sur la ligne 134, sont représentés les résultats utiles obtenus après les sommations par l'additionneur 54 des données d0, d2, d4, d6, d8, d10, d12, d14 et d16 appliquées à l'entrée 102 respectivement avec les données d1, d3, d5, d7, d9, d11, d13 et d15 appliquées à l'entrée 112. Ces sommations sont effectuées pour chaque combinaison de niveaux logiques (m1=1, m2=1, s1=0) coïncidant avec les périodes T0, T2, T4, T6, T8, T10, T12 et T14. Ces périodes correspondent aux cycles de calculs produisant des résultats utiles dans ce mode de décimation. Lesdits cycles de calcul produisent, au bout d'une durée de huit périodes, nécessaire au balayage d'une ligne de l'image traitée, les séquences intermédiaires d0+d1, d2+d3, d4+d5, d6+d7 qui sont mémorisées dans le moyen de stockage 46. Les combinaisons de niveaux logiques ( m1=0, m2=0, s1=1) coïncidant avec les périodes T1, T3, T5, T7, T9, T11, T13 et T15 correspondent à des cycles de calculs produisant des résultats inutiles symbolisés par des croix sur la ligne 134. Ces résultats ne sont pas mémorisés dans le moyen de stockage 46 et les cycles de calcul qui les produisent sont utilisés, à partir de la période T9, pour calculer, à chaque combinaison de niveaux logiques ( m1=0, m2=0, s1=1 ), les sommes (D1=d0+d1+d8+d9), (D2=d2+d3+d10+d11), (D3=d4+d5+d12+d13), (D4=d6+d7+d14+d15) des séquences (d0+d1). (d2+d3), (d4+d5), (d6+d7) préalablement mémorisées dans le registre 90 et des résultats utiles (d8+d9), (d10+d11), (d12+d13) et (d14+d15) calculés respectivement pendant les périodes T8, T10, T12 et T14. Notons que le calcul de chaque somme D1, D2, D3 et D4 est effectué pendant les périodes qui produisaient des résultats inutiles dans les dispositifs de l'art antérieur. Sur les figures 5 et 6 sont représentés en gras les chemins empruntés par les donnés aiguillées par l'étage de multiplexage corrélativement aux combinaisons des niveaux logiques des signaux m1, m2, s1 et s2. La figure 5 représente un premier chemin correspondant aux combinaisons successives (m1=m2=0, s1=1), tandis que la figure 6 représente un deuxième chemin correspondant aux combinaisons successives (m1=m2=1, s1=0).

Bien entendu, la combinaison des signaux m1, m2 et s1 peut être modifiée aisément par le moyen de commande de manière à réaliser un autre mode de décimation. Ces combinaisons peuvent être adaptées pour permettre de stocker conjointement, dans les registres 90 et 92 des séquences résultant du balayage de deux lignes successives de l'image traitée. Dans ce cas le moyennage ne concerne que des séquences de données représentant des pixels appartenant à la même trame. Par ailleurs, le dispositif peut être utilisé pour décimer des données représentant un signal quelconque, préalablement échantillonné, et dont les échantillons constituent les séquences successives d'un bloc monodimensionnel. Dans ce cas N=1 et le moyen de stockage 46 est constitué par un seul registre.

## Revendications

1. Dispositif de décimation de séquences de données représentant des valeurs des échantillons d'un signal à sous-échantillonner, chacun desdits échantillons étant représenté par un élément matriciel P(i,j) d'une matrice de N lignes et M colonnes, **caractérisé en ce qu'**il comporte un étage de multiplexage (40) ayant une pluralité d'entrées (42) recevant chacune une séquence de données, ledit étage de multiplexage (40) étant monté en cascade avec un étage de calcul (44) propre à effectuer, alternativement, pendant un premier cycle de calcul, la moyenne Mᵢ d'au moins deux séquences représentant le échantillons P(i,j) et P(i,j+1) situés sur une ligne L_{i,} i variant de 0 à N-1 et j variant de 0 à M-1, et pendant le cycle de calcul suivant, la moyenne Mc de la moyenne Mi obtenue, et d'une séquence intermédiaire préalablement calculée et mémorisée dans un moyen de stockage (46), ladite séquence intermédiaire représentant la moyenne Mᵢ₋₁ d'au moins deux échantillons P(i-1,j) et P(i-1,j+1) situés sur la ligne L_{i-1.}

2. Dispositif selon la revendication 1, **caractérisé en ce qu'**il comporte en outre un module de commande (50) foumissant, d'une part, à l'étage de calcul (44) un signal k permettant de sélectionner un mode parmi une pluralité de modes de décimation possibles, et d'autre part, à l'étage de multiplexage (40), un signal m permettant d'aiguiller vers l'étage de calcul (44), au moins deux séquences parmi les séquences reçues, corrélativement au mode de décimation sélectionné.

3. Dispositif selon la revendication 2, **caractérisé en ce que** l'étage de calcul (44) comporte un additionneur (54) relié via un registre tampon (55) à un diviseur programmable (80), ledit diviseur (80) recevant du moyen de commande (50) un signal représentant un coefficient de division choisi corrélativement au mode de décimation sélectionné, ledit registre tampon (55) recevant du moyen de commande (50) un signal périodique s1 commandant le transfert vers le moyen de stockage (46) des séquences correspondant à des résultats utiles calculés par l'additionneur (54).

4. Dispositif selon les revendications 1 à 3, **caractérisé en ce que** chaque élément matriciel p(i,j) représente les échantillons d'un signal vidéo envoyé à un pixel d'une image numériques de N lignes et M colonnes.

5. Dispositif selon la revendication 4, **caractérisé en ce que** le moyen de stockage (46) est constitué par un premier registre (90) associé à un deuxième registre (92), chacun desdits registres (90) et (92) étant destiné à stocker les échantillons numériques correspondant aux signaux vidéo d'au moins quatre pixels de l'image traitée.

6. Dispositif selon la revendication 5, **caractérisé en ce que** l'étage de multiplexage (40) comporte deux multiplexeurs, soit un premier multiplexeur (100) comportant trois entrées (102), (104), (106) et une sortie (108), et recevant du moyen de commande (50) un signal m1 de sélection de l'une des entrées (112), (114) ou (116) et un deuxième multiplexeur (110) comportant trois entrées (112), (114), (116) et une sortie (118), et recevant du moyen de commande (50) un signal de sélection m2 de l'une des entrées (112), (114) ou (116), lesdits multiplexeurs (100) et (110) sont assemblés de telle sorte que l'entrée (102) reçoive directement une séquence de données numériques, rentrée (112) soit reliée à l'entrée (102) à travers un opérateur de retard (120), l'entrée (104) soit reliée à une première borne (122) du registre (90), les entrées (106) et (114) soient reliées à une deuxième borne (124), commune aux registres (90) et (92) et rentrée (116) soit reliée à une troisième borne (126) dudit registre (92).

7. Dispositif selon les revendications 1 et 4, **caractérisé en ce que** N=1.

8. Dispositif selon la revendication 5, **caractérisé en ce que** ledit moyen de stockage (46) est agencé entre une sortie de rétage de calcul (44) et l'une au moins des entrées (42) de l'étage de multiplexage (40).

## Patentansprüche

1. Vorrichtung zur Dezimierung von Datenfolgen, die Abtastwerte eines unterabzutastenden Signals darstellen, wobei jeder der Abtastwerte durch ein Matrixelement P(i,j) einer Matrix mit N Zeilen und M Spalten dargestellt wird,
**dadurch gekennzeichnet, daß**
die Vorrichtung eine Multiplexierstufe (40) mit mehreren Eingängen (42) enthält, von denen jeder eine Datenfolge empfängt, daß die Multiplexierstufe (40) mit einer Berechnungsstufe (44) in Kaskade angeordnet ist, die in der Lage ist, abwechselnd während eines ersten Berechnungszyklus den Mittelwert Mᵢ von wenigstens zwei Folgen zu bewirken, die die Abtastwerte P(i,j) und P(i,j+1) darstellen, die auf einer Reihe Lᵢ liegen, wobei i sich von 0 bis N-1 ändert und j sich von 0 bis N-1 ändert, um während des folgenden Berechnungszyklus den Mittelwert Mc des gewonnenen Mittelwerts Mi und einer Zwischenfolge zu bewirken, die vorher berechnet und in einem Speichermittel (46) gespeichert wurde, wobei die Zwischenfolge den Mittelwert Mᵢ₋₁ von wenigstens zwei Abtastwerten P(i-1,j) und P(i-1,j+1) auf einer Zeile Lᵢ₋₁ darstellt.

2. Vorrichtung nach Anspruch 1, **dadurch gekennzeichnet, daß** sie außerdem ein Steuermodul (50) enthält, das einerseits zu der Berechnungsstufe (44) ein Signal k liefert, das es ermöglicht, einen Modus unter mehreren möglichen Modi für eine Dezimierung zu wählen, und andererseits zu der Multiplexierstufe (40) ein Signal m liefert, das es ermöglicht, aus der Berechnungsstufe (44) wenigstens zwei Folgen unter den empfangenen Folgen zu leiten, korrelativ zu dem gewählten Dezimierungsmodus.

3. Vorrichtung nach Anspruch 2, **dadurch gekennzeichnet, daß** die Berechnungsstufe (44) eine Addierstufe (54) enthält, die über ein Pufferregister (55) mit einem programmierbaren Teiler (80) verbunden ist, daß der Teiler (80) von dem Steuermodul (50) ein Signal empfängt, das einen Devisor darstellt, der korrelativ mit dem gewählten Dezimierungsmodus gewählt ist, und daß das Speicherregister (55) von dem Steuermodul (50) ein periodisches Signa s1 empfängt, das die Übertragung der durch die Addierstufe berechneten Folgen zu den Speichermitteln (46) steuert.

4. Vorrichtung nach einem der Ansprüche 1 bis 3, **dadurch gekennzeichnet, daß** jedes Matrixelement p(i,j) Abtastwerte eines Videosignals darstellt, das zu einem Pixel eines digitalen Bildes mit N Zeilen und M Spalten gesendet wird.

5. Vorrichtung nach Anspruch 4, **dadurch gekennzeichnet, daß** die Speichermittel (46) durch ein erstes Register (90) gebildet sind, dem ein zweites Register (92) zugeordnet ist, daß beide Register (90) und (92) dazu bestimmt sind, digitale Abtastwerte zu speichern, die den Videosignalen von wenigstens vier Pixeln des verarbeiteten Bildes entsprechen.

6. Vorrichtung nach Anspruch 5, **dadurch gekennzeichnet, daß** die Multiplexierstufe (40) zwei Multiplexer, nämlich einen ersten Muttiplexer (100) mit drei Eingängen (102), (104), (106) und einem Ausgang (108) enthält und von den Steuermitteln ein Signal m1 zur Auswahl eines der Eingänge (112), (114) oder (116) und einen zweiten Multiplexer (110) mit drei Eingängen (112), (114), (116) und einem Ausgang (118), und von den Steuermitteln (50) ein Signal m2 zur Wahl eines der Eingänge (112), (114) oder (116) empfängt, und die Multiplexer (100) und (110) derart angeordnet sind, daß der Eingang (102) direkt eine Folge von digitalen Daten empfängt, der Eingang (112) entweder über einen Verzögerungsoperator (120) mit dem Eingang (102), der Eingang (104) mit dem einer ersten Anschlußklemme (122) des Registers (90) verbunden ist, daß die Eingänge (106) und (114) mit einer zweiten Anschlußklemme (124) verbunden sind, die den Registern (90) und (92) gemeinsam sind, und daß der Eingang (116) mit einer dritten Anschlußklemme (126) des Registers (92) verbunden ist.

7. Vorrichtung nach Anspruch 1 und 4, **dadurch gekennzeichnet, daß** N = 1 ist.

8. Vorrichtung nach Anspruch 5, **dadurch gekennzeichnet, daß** die Speichermittel (46) zwischen einem Ausgang der Berechnungsstufe (44) und wenigstens einem der Eingänge (42) der Multiplexierstufe (40) angeordnet sind.

## Claims

1. Device for decimating data sequences representing values of the samples of a signal to be subsampled, each of the said samples being represented by a matrix element P(i, j) of a matrix of N rows and M columns, **characterized in that** it comprises a multiplexing stage (40) having a plurality of inputs (42) each receiving a data sequence, the said multiplexing stage (40) being arranged in cascade with a calculation stage (44) able to compute, alternately, during a first calculation cycle, the average Mᵢ of at least two sequences representing the samples P(i, j) and P(i, j + 1) situated on a row Lᵢ, i varying from 0 to N - 1 and j varying from 0 to M - 1 and during the next calculation cycle, the average Mc of the average Mi obtained, and of an intermediate sequence calculated previously and stored in a storage means (46), the said intermediate sequence representing the average M_{i - 1} of at least two samples P(i - 1, j) and P(i - 1, j + 1) situated on the row L_{i - 1.}

2. Device according to Claim 1, **characterized in that** it furthermore comprises a control module (50) delivering, on the one hand, to the calculation stage (44), a signal k making it possible to select one mode from a plurality of possible decimation modes, and on the other hand, to the multiplexing stage (40), a signal m making it possible to route to the calculation stage (44), at least two sequences from the sequences received, correlatively with the selected decimation mode.

3. Device according to Claim 2, **characterized in that** the calculation stage (44) comprises an adder (54) linked via a buffer register (55) to a programmable divider (80), the said divider (80) receiving from the control means (50) a signal representing a division coefficient chosen correlatively with the selected decimation mode, the said buffer register (55) receiving from the control means (50) a periodic signal s1 controlling the transfer to the storage means (46) of the sequences corresponding to useful results calculated by the adder (54).

4. Device according to Claims 1 to 3, **characterized in that** each matrix element p(i, j) represents the samples of a video signal sent to a pixel of a digital image of N lines and M columns.

5. Device according to Claim 4, **characterized in that** the storage means (46) consists of a first register (90) associated with a second register (92), each of the said registers (90) and (92) being intended to store the digital samples corresponding to the video signals of at least four pixels of the processed image.

6. Device according to Claim 5, **characterized in that** the multiplexing stage (40) comprises two multiplexers, i.e. a first multiplexer (100) comprising three inputs (102), (104), (106) and an output (108), and receiving from the control means (50) a signal m1 for selecting one of the inputs (112), (114) or (116) and a second multiplexer (110) comprising three inputs (112), (114), (116) and an output (118), and receiving from the control means (50) a signal m2 for selecting one of the inputs (112), (114) or (116), the said multiplexers (100) and (110) are assembled in such a way that the input (102) receives a digital data sequence directly, the input (112) is linked to the input (102) through a delay operator (120), the input (104) is linked to a first terminal (122) of the register (90), the inputs (106) and (114) are linked to a second terminal (124), common to the registers (90) and (92) and the input (116) is linked to a third terminal (126) of the said register (92).

7. Device according to Claims 1 and 4, **characterized in that** N = 1.

8. Device according to Claim 5, **characterized in that** the said storage means (46) is disposed between an output of the calculation stage (44) and one at least of the inputs (42) of the multiplexing stage (40).
